Europäisches Patentamt

**European Patent Office**

Office européen des brevets

(11) Publication number: **0 199 966**
**B1**

# EUROPEAN PATENT SPECIFICATION

(45) Date of publication of the patent specification:
**12.12.90**

(51) Int. Cl.⁵: **C23F 1/12**, C23C 4/04,
B44C 1/22
// H01L21/00

(21) Application number: **86103744.8**

(22) Date of filing: **19.03.86**

(54) Method of plasma etching a substrate.

(30) Priority: **01.04.85 US 718246**

(43) Date of publication of application:
**10.12.86 Bulletin 86/45**

(45) Publication of the grant of the patent:
**12.12.90 Bulletin 90/50**

(84) Designated Contracting States:
**DE FR GB IT**

(56) References cited:
**US-A- 4 092 210**
**US-A- 4 174 251**
**US-A- 4 180 432**

**PATENT ABSTRACTS OF JAPAN, unexamined
applications, C field, vol. 8, no. 130, June 16, 1984, THE
PATENT OFFICE JAPANESE GOVERNMENT, p. 70 C 229**

(73) Proprietor: **International Business Machines
Corporation, Old Orchard Road, Armonk, N.Y. 10504(US)**

(72) Inventor: **Babu, Suryadevara Vijayakumar, One Carol
Court, Potsam, N.Y. 13676(US)**
Inventor: **Hoffarth, Joseph Gerard, RD3, Poplar Hill
Road, Binghamton, N.Y. 13901(US)**
Inventor: **Knoll, Allan Robert, 106 Smithfield Drive,
Endicott, N.Y. 13760(US)**
Inventor: **Mlynko, Walter Eugene, 138 Jensen Road, E25,
Vestal, N.Y. 13850(US)**
Inventor: **Rembetski, John Francis, 985 North Avenue,
A-8, Burlington, Vt. 05401(US)**

(74) Representative: **Mönig, Anton, Dipl.-Ing., IBM
Deutschland GmbH Patentwesen und Urheberrecht
Schönaicher Strasse 220, D-7030 Böblingen(DE)**

## EP 0 199 966 B1

### Description

This invention relates to a process for plasma etching a substrate.

In recent years, in the field of surface processing of substrates such as organic polymers and semiconductors, the conventional wet processing method has been extensively replaced by a dry etching processing method. In this so-celled dry etching technique, the surface to be etched is exposed to a plasma established by a high frequency glow discharge. For example, U.S. Patent No. 3 795 557 (Reissue 30 505) discloses exposing a semi-conductor material such as Si, GaAs, InSb having a relatively thin (20 to 1000 nm) layer of a dielectric material e.g. SiO, $SiO_2$, $Si_3N_4$, either deposited or thermally grown onto the semiconductor, to a gaseous plasma formed from a binary mixture consisting essentially of oxygen and an organohalide compound such as tetrafluoromethane ($CF_4$), the mixture containing 1 to 75 percent oxygen by volume. Other patents which contain similar teachings of plasma etching using organohalide/oxygen mixtures include U.S. Patent Nos. 4 174 251, 4 180 432, 4 374 699, and 4 487 652. U.S. Patent Nos. 4 357 203, 4 460 436, and 4 482 427 are exemplary of prior art use of $O_2$ being the sole constituent of a plasma etchant. U.S. 4 487 652 further teaches the use of an oxygen plasma to clear underlying photoresist and polyimide layers which remain on a substrate after plasma etching of the overlying oxide and a part of the photoresist and polyimide layers with an organohalide/oxygen mixture is completed.

One drawback to the use of organohalide/oxygen mixtures is often the gaseous mixture halogenates the surface of the substrate undergoing plasma etching and forms a halogen contaminated film surface on the substrate. The formation of the halogenated film, or the existence of a halogen contaminated substrate surface, slows the etch rate of the plasma and thereby unduly prolongs the time required for etching. Further, the presence of the halogen contaminated surface will interfere with subsequent processing steps which are intended for the etched substrate, e.g. plating, lamination and adhesion to other later applied layers of organic or inorganic materials.

Because of the demand for ever-higher speeds of operation and the need for reliably prepared semi-conductor components, there has been a considerable effort in the electronics industry to resolve the halogenated surface film problem. This is also the object of the present invention.

This object is achieved by a process as defined in claim 1.

The inventive process is based on the discovery that plasma etching process employing the use of different gaseous plasma compositions for dry etching apparently substantially eliminates the etch rate inhibiting halogen surface film previously encountered with organohalide containing plasmas. The plasma etching process of the present invention facilitates, in particular, the process of etching organic polymeric substrates at an extremely rapid rate that is much higher than any encountered in the prior art by using the etching properties of the halogen containing surface layers.

As will hereinafter be demonstrated, by substituting a plasma consisting essentially of oxygen for the organohalide containing gas initially used to perform the dry etching process, the etch rate increases almost instantaneously upon such substitution by several orders of magnitude.

Other advantageous embodiments of the inventive process are disclosed in the subclaims.

The inventive process will become more apparent from the following detailed description.

In effecting dry etching in accordance with the practice of the present invention, the initial etchant gas is comprised of a volatile organohalide compound such as $CF_4$, $CCl_4$, $CF_2Cl_2$ and $CFCl_3$ alone or as a binary mixture with oxygen. When binary mixtures are used as the etchant gas, the mixture generally contains on a volume basis, from about 20 to about 100 percent of the organohalide and from about 0 to about 80 percent by volume oxygen. Preferably, the gaseous binary mixture contains about 30 to about 60 volume percent of the organohalide and about 40 to about 70 volume percent oxygen. Carbon tetrafluoride ($CF_4$) is the organohalide gas preferred for use in the initial etching step of the plasma etching process of the present invention.

The substrate receiving the sequential plasma etch treatment of the present invention is continuously etched. The substrate may be of any material which is conventionally etched using organohalide containing plasmas, as for example, organic polymers such as epoxy resin lacquers, polyimides, photoresists, semiconductor material such as Si, GaAs, InP, $Si_3N_4$, and $SiO_2$. The process of the present invention may also be used to treat perfluorinated surfaces, as in textile or synthetic fiber substrates wherein it is necessary to clean the surface to return it to its original properties.

The plasma etching process of the present invention is conveniently conducted in a parallel plate reactor of the type conventionally used for plasma etching of semi-conductor materials. In such reactor an upper electrode can be powered to between 50 and 500 watts and a second, lower electrode tuned to about 0 to 100 volts with respect to the ground. The total gas pressure utilized is typically 13,33 µbar to 666,5 µbar (10 to 500 mTorr) and the total gas flow is typically 30 to 300 sccm.

In practicing the plasma etching process of the present invention, the specimen of the substrate material to be etched is mounted on the lower electrode of the reactor. The gas containing the organohalide compound with or without oxygen is introduced into the reactor and a high frequency (RF) power is applied between the first and seconde electrode to produce a plasma between the first electrode and second electrode. The substrate material is exposed to this organohalide containing plasma for about 0.5 to about 5 minutes or until the etch rate has stabilized at a low rate, e.g. 5 to 1000 nm/minute as indicated by etch rate measurements, such as laser interferometry. Thereafter the gas atmosphere in the reactor is changed to 100% by volume oxygen by stopping the flow of the organohalide to the reactor and replacing the organohalide flow with oxygen. Upon the replacement of the organohalide with oxygen in the reactor, the etch rate will instantaneously increase to 3000 nm/minute or higher. This enhanced etch rate will generally last for a very short time period, i.e. less than about 2 minutes, e.g. about 10 seconds to 2 minutes and then stabilize at a considerably lower rate that reflects the substrate etch rate in pure oxygen e.g. 500 nm/minute.

This procedure is applicable when the etching is accomplished in the plasma reactor i.e. in the plasma mode, in the reaction ion mode or in a floating substrate mode.

The following Example further illustrates the invention, it being understood that the invention is in no way intended to be limited to the details described therein.

Example

A series of 50–70 um thick epoxy resin coated silicon coupons were utilized as substrates. Each coupon to be etched was placed on the lower electrode of a parallel electrode plasma etching reactor. The lower electrode was RF powered and the upper electrode was either grounded or maintained at an arbitrary floating potential. The input RF power was 400 watts and the pressure during etching was 133,32 $\mu$bar (100 mTorr). The total gas flow averaged about 60 sccm. Etching was initially carried out using varying percent volume ratios of $CF_4$ and $O_2$. Etch rates were measured simultaneously by laser interferometry. After the etch rate of the epoxy resin coated coupon settled at a low steady state value which normally occurred in about 0.5 to about 5.0 minutes after admission of the $CF_4/O_2$ etchant gas mixture to the plasma reactor and turning on the RF power, the flow of $CF_4$ gas to the reactor was interrupted and replaced with $O_2$ gas. Upon replacement of the $CF_4/O_2$ etching gas mixture with 100 volume percent $O_2$, there was an immediate increase in the etch rate. Maximum etch rates, with 100 volume percent $O_2$ atmosphere were achieved within 15–25 seconds. Thereafter the etch rates declined rapidly and reached a stabilized etch rate of 300–500 nm/minute, at which time the etching process was terminated.

The etch rates of the epoxy resin coated coupons when first exposed to a $CF_4/O_2$ etching gas mixture and the maximum rates measured when the gas mixture was replaced by 100 volume percent $O_2$ are summarized in the Table below:

TABLE

| Initial Etch Gas Composition (volume %) | Epoxy Etch Rate (nm/min) | Maximum Etch Rate When Gas Mixture Was Replaced by $O_2$ (nm/min) |
|---|---|---|
| 40% $O_2$, 60% $CF_4$ | 8.5 | 2,900 |
| 60% $O_2$, 40% $CF_4$ | 32 | 13,000 |
| 70% $O_2$, 30% $CF_4$ | 700 | 10,500 |

By reference to the data recorded in the Table, it is immediately apparent that the replacement of the $CF_4/O_2$ gas mixture with $O_2$ unexpectedly results in a dramatic increase in etch rates which is 15–400 times greater than the etch rate previously achieved with the $CF_4/O_2$ gas mixture.

While specific components of the present system are defined above, many other variables may be introduced which may in any way affect, enhance, or otherwise improve the system of the present invention. These are intended to be included herein.

Although variations are shown in the present application, many modifications and ramifications will occur to those skilled in the art upon a reading of the present disclosure. These, too, are intended to be included herein.

**Claims**

1. A process for plasma etching a substrate, which process comprises the sequential steps of first exposing the substrate to a gaseous plasma containing an organohalide, etching the substrate in the gaseous plasma until the rate at which the substrate is etched reaches a stabilized value and then replacing the organohalide containing etchant gas with oxygen gas and further etching the substrate with oxygen plasma, where the material exposed first to the organohalide containing plasma and subsequently to the oxygen plasma is the same.

2. Process according to claim 1 wherein the substrate is an organic polymer coating.

3. Process according to claim 1 wherein the substrate is a semiconductor material having a dielectric material deposited thereon.

4. Process according to any one of claims 1 to 3 wherein the organohalide is $CF_4$.

5. Process according to any one of claims 1 to 4 wherein the etchant gas used in the first exposure of the substrate is a mixture of $CF_4$ and $O_2$.

6. Process according to claim 5 wherein the etchant gas contains on a volume basis about 20 to about 100 volume percent of the organohalide and about 0 to about 80 volume percent oxygen.

7. Process according to claim 5 or 6 wherein the substrate is first etched with etchant gas containing the organohalide for about 0.5 to about 5.0 minutes and then etched in the oxygen plasma for less than about 3.0 minutes.

**Patentansprüche**

1. Verfahren zum Plasmaätzen eines Substrats, bei dem in aufeinanderfolgenden Schritten zuerst das Substrat in einem gasförmigen, ein organisches Halogenid enthaltenden Plasma geätzt wird, bis die Geschwindigkeit, mit der das Substrat geätzt wird, einen stabilen Wert erreicht hat, und bei dem anschließend das das organische Halogenid enthaltende Ätzgas durch Sauerstoffgas ersetzt und weiterhin das Substrat mit Sauerstoffplasma geätzt wird, wobei das zuerst dem ein organisches Halogenid enthaltenden Plasma und anschließend dem Sauerstoffplasma ausgesetzte Material dasselbe ist.

2. Verfahren nach Anspruch 1, bei dem das Substrat eine organische Polymerschicht ist.

3. Verfahren nach Anspruch 1, bei dem das Substrat ein Halbleitermaterial mit einem darauf abgeschiedenen dielektrischen Material ist.

4. Verfahren nach einem der Ansprüche 1 bis 3, bei dem das organische Halogenid $CF_4$ ist.

5. Verfahren nach einem der Ansprüche 1 bis 4, bei dem das Substrat zuerst einem Ätzgas ausgesetzt wird, welches aus einer Mischung von $CF_4$ und $O_2$ besteht.

6. Verfahren nach Anspruch 5, bei dem das Ätzgas ca. 20 bis ca. 100 Volumprozent des organischen Halogenids und ca. 0 bis ca. 80 Volumprozent Sauerstoff enthält.

7. Verfahren nach Anspruch 5 oder 6, bei dem das Substrat zuerst während ca. 0,5 bis ca. 5,0 Minuten mit dem das organische Halogenid enthaltenden Ätzgas und anschließend während weniger als ca. 3,0 Minuten im Sauerstoffplasma geätzt wird.

**Revendications**

1. Procédé pour la gravure par plasma d'un substrat, lequel procédé comprend les étapes successives consistant à exposer tout d'abord le substrat à un plasma gazeux contenant un composé organique halogéné, à attaquer le substrat dans le plasma gazeux jusqu'à ce que la vitesse à laquelle le substrat est attaqué atteigne une valeur stabilisée, puis à remplacer le gaz d'attaque contenant le composé organique halogéné par de l'oxygène gazeux, et à attaquer encore le même substrat par le plasma d'oxygène, dans lequel le matériau exposé en premier lieu au plasma contenant le composé organique halogéné et en second lieu au plasma d'oxygène est le même.

2. Procédé selon la revendication 1, dans lequel le substrat est un revêtement de polymère organique.

3. Procédé selon la revendication 1, dans lequel le substrat est un matériau semi-conducteur sur lequel a été déposé un matériau diélectrique.

4. Procédé selon l'une quelconque des revendications 1 à 3, dans lequel le composé organique halogéné est $CF_4$.

5. Procédé selon l'une quelconque des revendications 1 à 4, dans lequel le gaz d'attaque utilisé dans la première exposition du substrat est un mélange de $CF_4$ et $O_2$.

6. Procédé selon la revendication 5, dans lequel le gaz d'attaque contient, sur une base de volume, environ 20 à environ 100 pour cent en volume du composé organique halogéné et environ 0 à environ 80 pour cent en volume d'oxygène.

7. Procédé selon la revendication 5 ou 6, dans lequel le substrat est d'abord attaqué pendant environ 0,5 à environ 5,0 minutes par le gaz d'attaque contenant le composé organique halogéné, puis attaqué pendant moins d'environ 3,0 minutes dans le plasma d'oxygène.